# EUROPEAN PATENT SPECIFICATION

(11) **EP 2 858 252 B1**
(45) Date of publication and mention of the grant of the patent: **19.01.2022**
(21) Application number: 13796616.4
(22) Date of filing: 22.05.2013
(51) Int. Cl.: H04B 1/16, H03J 5/00, H03J 7/18, H04H 60/43, H04N 21/438

(54) **RECEPTION DEVICE, RECEPTION METHOD, AND PROGRAM**
EMPFANGSVORRICHTUNG, EMPFANGSVERFAHREN UND PROGRAMM
DISPOSITIF DE RÉCEPTION, PROCÉDÉ DE RÉCEPTION ET PROGRAMME

(30) Priority: 31.05.2012 JP 2012124389
(43) Date of publication of application: 08.04.2015
(73) Proprietor: Saturn Licensing LLC, New York, NY (US)
(72) Inventor: YOSHIMOCHI, Naoki, Tokyo 108-0075 (JP); YOKOKAWA, Takashi, Tokyo 108-0075 (JP); KOBAYASHI, Kenichi, Tokyo 108-0075 (JP)
(74) Representative: D Young & Co LLP
(86) International application number: PCT/JP2013/064225
(87) International publication number: WO 2013/179975

(56) References cited:
- EP-A2- 2 237 415
- EP-A2- 2 398 232
- JP-A- 2007 214 977
- US-A1- 2011 242 428
- European Standard: "Digital Video Broadcasting (DVB); Frame structure channel coding and modulation for a second generation digital terrestrial television broadcasting system (DVB-T2)", , 1 November 2011 (2011-11-01), pages 1-189, XP055228422, Retrieved from the Internet: URL:http://www.etsi.org/deliver/etsi_en/30 2700_302799/302755/01.03.01_40/en_302755v0 10301o.pdf [retrieved on 2015-11-13]
- ETSI TS 102 773 V1.3.1 (2012-01) DIGITAL VIDEO BROADCASTING (DVB); MODULATOR INTERFACE (T2-MI) FOR A SECOND GENERATION DIGITAL TERRESTRIAL TELEVISION BROADCASTING SYSTEM (DVB-T2), ETSI 05 January 2012, pages 12 - 35, XP014069234

## Description

### Technical Field

The present technology relates to reception devices and reception methods, and programs, and more particularly, to a reception device and reception method, and program which, when receiving a signal compliant with the DVB-T2 standard, allow for efficient and quick channel scanning and tuning.

### Background Art

A digital terrestrial broadcasting standard called the European digital terrestrial broadcasting standard DVB-T (Digital Video Broadcasting for Terrestrial) has been provided. DVB-T is a digital terrestrial broadcasting standard which is employed in countries in the world as well as Europe.

Reception devices and transmission devices have been designed and commercialized based on the DVB-T standard.

However, recently, DVB-T2 (Digital Video Broadcasting Terrestrial 2), which is an improved version of DVB-T, has been brought into practical use, and broadcasting was started for the first time on December, 2009 in the United Kingdom (see Non-Patent Literature 1). DVB-T2, which is a new standard which is an improved version of the above DVB-T, has a much larger transmission capacity than that of DVB-T, and has a configuration which can effectively use a band, thereby achieving higher HD (High Definition) broadcasting.

### Citation List

### Non-Patent Literature

Non-Patent Literature 1: Digital Video Broadcasting (DVB); Implementation guidelines for a second generation digital terrestrial television broadcasting system (DVB-T2)

### Summary of Invention

### Technical Problem

Incidentally, DVB-T2 has further evolved. Version 1.3.1 or later of DVB-T2 allows for transmission of a broadcast signal multiplexed with T2-Lite, which is a profile for mobile devices, in addition to T2-Base, which is a profile which has been so far used.

As a result, in Version1.3.1 or later, different profiles are used during different time zones in each frequency band, while, in Version 1.2.1 or earlier of DVB-T2, once a profile has been designated for each frequency band, the same profile is transmitted in the same band during any time zone.

Therefore, when the reception channel of a signal transmitted according to DVB-T2 is scanned, it is necessary to scan all channels for T2-Lite, which is a new profile for mobile devices, in addition to T2-Base, which is a conventional profile, and therefore, it is likely to simply take a double time to search channels. Also, when a profile to be first scanned is designated for each channel, complicated settings are likely to be required in order to speed up the scanning process.

With such circumstances in mind, the present technology has been made. In particular, it is an object of the present technology to allow for efficient and quick scanning of all channels including T2-Base, which is a conventional profile in DVB-T2, and T2-Lite, which is a new profile for mobile devices, and efficient tuning in to a channel after scanning.

European Standard: "Digital Video Broadcasting (DVB); Frame structure channel coding and modulation for a second generation digital terrestrial television broad casting system (DVB-T2)" describes the DVB-T2 standard.

### Solution to Problem

Various aspects of the invention are set out in the accompanying claims.

### Advantageous Effects of Invention

According to one aspect of the present technology, when a signal compliant with the DVB-T2 standard is received, channel scanning and channel tuning can be efficiently and quickly performed.

### Brief Description of Drawings

[FIG. 1] FIG. 1 is a block diagram showing an example configuration of a first embodiment of a reception device to which the present technology is applied.
[FIG. 2] FIG. 2 is a diagram for describing an example configuration of the T2 frame.
[FIG. 3] FIG. 3 is a diagram for describing allocation of the S1 field.
[FIG. 4] FIG. 4 is a diagram for describing allocation of the S2 field 2.
[FIG. 5] FIG. 5 is a diagram for describing allocation of broadcast signals in the frequency band and time directions.
[FIG. 6] FIG. 6 is a diagram for describing use cases of broadcast signals.
[FIG. 7] FIG. 7 is a flowchart for describing a scanning process by the reception device of FIG. 1.
[FIG. 8] FIG. 8 is a block diagram showing an example configuration of a second embodiment of a reception device to which the present technology is applied.
[FIG. 9] FIG. 9 is a flowchart for describing a scanning process by the reception device of FIG. 8.
[FIG. 10] FIG. 10 is a flowchart for describing a first reception mode process.
[FIG. 11] FIG. 11 is a flowchart for describing a second reception mode process.
[FIG. 12] FIG. 12 is a flowchart showing a tuning process (third reception mode process).
[FIG. 13] FIG. 13 is a diagram for describing an example configuration of a general-purpose personal computer.

### Description of Embodiments

Hereinafter, embodiments for carrying out the present invention (hereinafter referred to as "embodiments") will be described. Note that the description will be given in the following order.
1. First embodiment (an example in which, during channel scanning, after one profile has been received, scanning is performed for the other profile only when the other profile is included)
2. Second embodiment (an example in which three different reception mode processes are set, and channel scanning and channel tuning are implemented using a combination of these reception modes)

### <First Embodiment>

### [Example Configuration of First Embodiment of Reception Device]

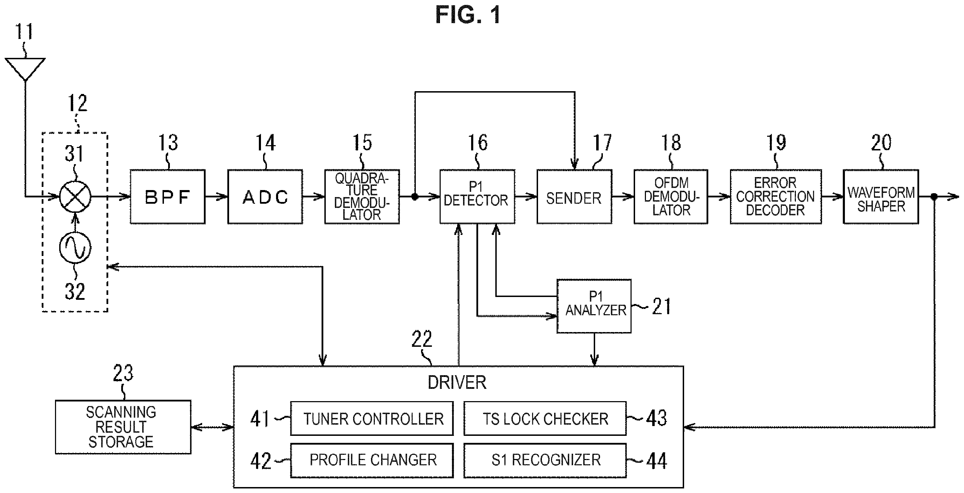

FIG. 1 shows an example configuration of a first embodiment of a reception device to which the present technology is applied. The reception device of FIG. 1 receives a broadcast signal compliant with the DVB-T2 broadcasting standard.

The reception device of FIG. 1 includes an antenna 11, a tuner 12, a BPF (Band Pass Filter) 13, an ADC (Analogue Digital Converter) 14, a quadrature demodulator 15, a PI detector 16, a sender 17, and an OFDM (Orthogonal Frequency Division Multiplexing) demodulator 18. Also, the reception device of FIG. 1 includes an error correction decoder 19, a waveform shaper 20, a PI interpreter 21, a driver 22, and a scanning result storage 23.

The tuner 12 includes a multiplier 31 and an oscillator 32. A wave received as an RF (Radio Frequency) signal by the antenna 11 is multiplied by an intermediate frequency signal oscillated by the oscillator 32 to be frequency-converted into an IF (Intermediate Frequency) signal, which is output to the BPF 13.

The BPF 13 performs a filtering process on the input IF signal so that only a predetermined band range signal is passed, and supplies the result of the filtering to the ADC 14.

The ADC 14 converts the input signal from an analog signal into a digital signal, and supplies the digital signal to the quadrature demodulator 15.

The quadrature demodulator 15 performs quadrature demodulation on the IF signal which has been converted into a digital signal by the ADC 14, using a carrier signal having a predetermined frequency (carrier frequency), and outputs a base-band signal to the PI detector 16 and the sender 17.

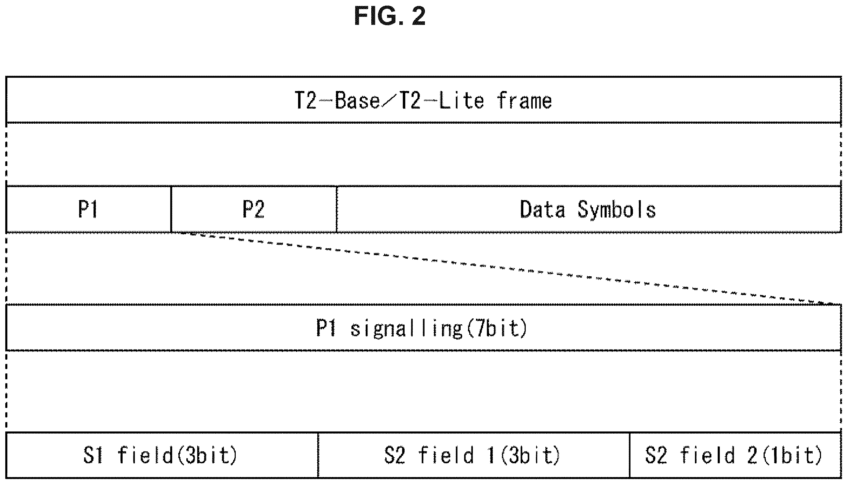

The PI detector 16 detects information of a PI symbol (hereinafter also simply referred to as "P1") provided in a header portion of the base-band signal, and supplies the information to a PI recognizer 21. Also, the PI detector 16 instructs the sender 17 to, or not to, send a supplied broadcast signal to the succeeding stage in accordance with an instruction from the PI recognizer 21 or the driver 22. Note that the configuration of a signal of DVB-T2 which includes a base-band signal will be described in detail below with reference to FIG. 2.

In accordance with the instruction from the PI detector 16, the sender 17 supplies the signal supplied from the quadrature demodulator 15 to the OFDM demodulator 18, in synchronization with the OFDM demodulator 18, at a timing when the sender 17 is instructed to send the signal. Also, when the sender 17 is instructed by the PI detector 16 to stop sending, the sender 17 does not send the signal supplied from the quadrature demodulator 15 to the OFDM demodulator 18, and directly discards the signal.

The OFDM demodulator 18 performs FFT (Fast Fourier Transform) and an equalization process on the signal supplied from the sender 17, and supplies the resultant signal to the error correction decoder 19.

The error correction decoder 19 performs error correction decoding on the supplied encoded signal, and outputs the result of the decoding to the waveform shaper 20.

The waveform shaper 20 performs waveform shaping on a signal which is the result of the decoding, and outputs the resultant signal as a TS (Transport Stream) to the succeeding stage, and feeds the TS which is the result of the decoding back to the driver.

The PI interpreter 21 interprets information of the PI symbol based on the information of the PI symbol supplied from the PI detector 16, and supplies the result of the interpretation to the PI detector 16 and the driver 22.

The driver 22 instructs the PI detector 16 to perform an operation on the sender 17, based on the result of the interpretation of the PI symbol supplied from the P1 interpreter 21, and causes the scanning result storage 23 to store one of the scanned channels which has been detected as a frequency at which a program is present. Moreover, when any of the channels stored in the scanning result storage 23 is designated based on what is indicated by an operation of an operation unit (not shown), the driver 22 controls the tuner 12 so that the tuner 12 tunes in to the frequency of the designated channel.

Also, the driver 22 includes a tuner controller 41, a profile changer 42, a TS lock checker 43, and an S1 recognizer 44. The tuner controller 41 controls the oscillation frequency of the oscillator 32 of the tuner 12 to control the channel of a signal received by the tuner 12. The profile changer 42 changes profiles which the PI detector 16 instructs the sender 17 to send, based on information of the profile of a signal included in the PI symbol supplied from the PI interpreter 21. The TS lock checker 43 checks a TS fed back from the waveform shaper 20 to determine whether or not the TS is output as a correct image, and when the TS is output as a correct image, determines that the TS has been locked. The S1 recognizer 44 recognizes the profile of the current signal indicated by the S1 field included in the P1 symbol supplied from the PI interpreter 21.

### [Structure of T2 Frame]

Next, the structure of the T2 frame, which is the structure of a signal transmitted as a broadcast signal, will be described with reference to FIG. 2.

The T2 frame is divided into two different frames, depending on the profile. For the profiles of the T2 frame, as shown at the uppermost row of FIG. 2, the T2-Base frame for receivers typified by a stationary television set etc., and the T2-Lite frame for receivers typified by mobile equipment etc., are set.

The T2 frame has a common structure which does not depend on the type of the profile. As shown in the second row of FIG. 2, the T2 frame includes a PI symbol, a P2 symbol, and data symbols, from the left in the figure (from the most significant bit).

Of them, as shown in the third row of FIG. 2, the PI symbol includes a 7-bit P1 signaling. Moreover, the P1 signaling includes a 3-bit S1 field, a 3-bit S2 field 1, and a 1-bit S2 field 2.

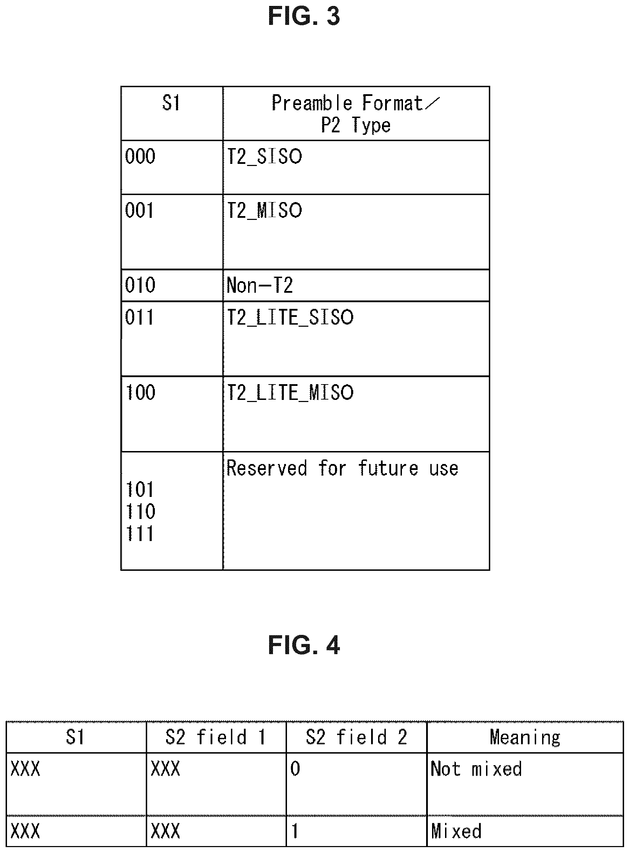

The S1 field indicates the profile of a signal of the T2 frame. As shown in FIG. 3, when the 3-bit signal is 000, it is indicated that the profile is T2_SISO (Single Input Single Output) of T2-Base. Also, when the S1 field is 001, it is indicated that the profile is T2_MISO (Multi Input Single Output) of T2-Base. Note that, in the description that follows, when the S1 field is any of 000 and 001, the profile is T2-Base. Also, when the S1 field is 010, it is indicated that the profile is a service extension frame called an FEF (Future Extension Frame).

Also, when the S1 field is 011, it is indicated that the profile is T2_LITE_SISO (Single Input Single Output) of T2-Lite. Also, when the S1 field is 100, it is indicated that the profile is T2_LITE_MISO (Multi Input Single Output) of T2-Lite. Also, when the S1 field is any of the remaining 101, 110, and 111, these are reserved for future use, i.e., reserved in order to deal with future changes in the standard.

Moreover, in the S2 field 1, information of the FFT size and the guard interval is recorded. The S2 field 2 indicates whether or not the profiles are all the same. As shown in the upper row of FIG. 4, when the S2 field 2 is 0, it is indicated that all signals in the same band have the same profile (Not mixed). Also, as shown in the lower row of FIG. 4, when the S2 field 2 is 1, it is indicated that signals in the same band include signals having a plurality of profiles (Mixed). Note that, in the description that follows, the S1 field is also simply referred to as "S1," and similarly, the S2 field 2 is also simply referred to as "S2."

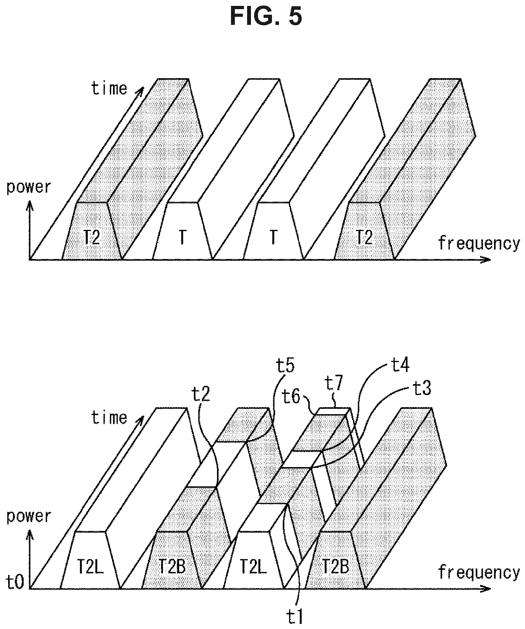

Specifically, in the conventional DVB-T, as shown in the upper portion of FIG. 5, in all bands, signals having the same profile are transmitted in any time zone. Note that, in the upper portion of FIG. 5, frequency bands (frequency) are set in the horizontal direction in the figure, time is set in the depth direction of the figure, and reception levels (power) are shown in the upward direction in the figure. Specifically, in the upper portion of FIG. 5, it is indicated that, from the left band, the profiles are DVB-T2 (T2), DVB-T (T), DVB-T (T), and DVB-T2 (T2), and remain unchanged in the time direction.

In contrast to this, in DVB-T2 to which the present technology is applied, the profile changes in the time direction in addition to the frequency band direction. Therefore, as shown in the lower portion of FIG. 5, in the leftmost band and the rightmost band in the figure, the profiles are fixed to DVB-T2-Lite (T2L) and DVB-T2-Base (T2B), respectively, in any time zone. However, in the second band from the left, it is indicated that while the profile is DVB-T2-Base (T2B) from time t0 to t2, the profile is changed to DVB-T2-Lite (T2L) from time t2 to t5, and then to DVB-T2-Base (T2B) from time 5. Similarly, in the second band from the right, it is indicated that while the profile is DVB-T2-Lite (T2L) from t0 to t1, the profile is changed to DVB-T2-Base (T2B) from t1 to t3, then to DVB-T2-Lite (T2L) from t3 to t4, then to DVB-T2-Base (T2B) from t4 to t6, and then to DVB-T2-Lite (T2L) from t5.

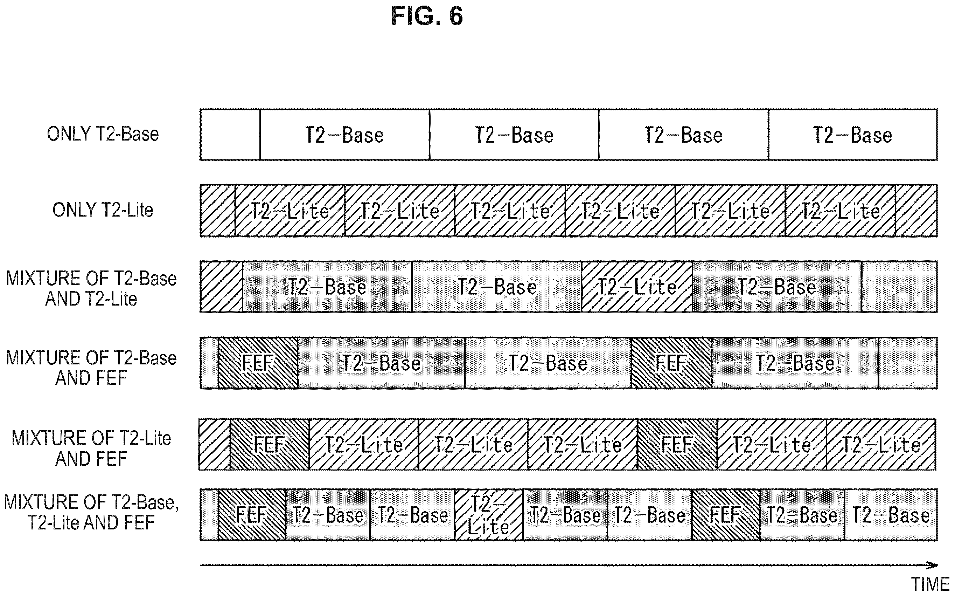

Moreover, DVB-T2 includes the two different profiles, i.e., DVB-T2-Base (T2B) and DVB-T2-Lite (T2L), and in addition, FEF. Therefore, for each band, there may be variations shown in FIG. 6.

Specifically, as shown in the uppermost row of FIG. 6, the profile may be invariably DVB-T2-Base (T2-Base) in the time direction, and as shown in the second row from the top of FIG. 6, the profile may be invariably DVB-T2-Lite (T2-Lite) in the time direction. Also, as shown in the third row from the top of FIG. 6, the profile may be changed between DVB-T2-Base (T2-Base) and DVB-T2-Lite (T2-Lite), i.e., there may be a mixture of DVB-T2-Base (T2-Base) and DVB-T2-Lite (T2-Lite), in the time direction. Similarly, as shown in the fourth row from the top, the profile may be changed between DVB-T2-Base (T2-Base) and FEF, i.e., there may be a mixture of DVB-T2-Base (T2-Base) and FEF, in the time direction. Moreover, as shown in the fifth row from the top of FIG. 6, the profile may be changed between FEF and DVB-T2-Lite (T2-Lite), i.e., there may be a mixture of FEF and DVB-T2-Lite (T2-Lite), in the time direction. And, as shown in the lowermost row of FIG. 6, the profile may be changed among FEF, DVB-T2-Base (T2-Base), and DVB-T2-Lite (T2-Lite), i.e., there may be a mixture of FEF, DVB-T2-Base (T2-Base), and DVB-T2-Lite (T2-Lite), in the time direction.

When the profile remains unchanged in the time direction as shown in the upper most row and the second row from the top of FIG. 6, information indicated in the S2 field 2 indicates that there is not a mixture, i.e., "0" indicating "Not mixed." Conversely, when the profile is changed in the time direction as shown in the fourth row from the top to the lowermost row of FIG. 6, information indicated in the S2 field 2 indicates that there is a mixture, i.e., "1" indicating "Mixed."

Thus, by recognizing, based on the information of the S1 field and the S2 field 2, the profile of a signal to be supplied, and whether or not there is a mixture of profiles, channel scanning and a tuning process can be efficiently and quickly performed.

### [Scanning Process by Reception Device of FIG. 1]

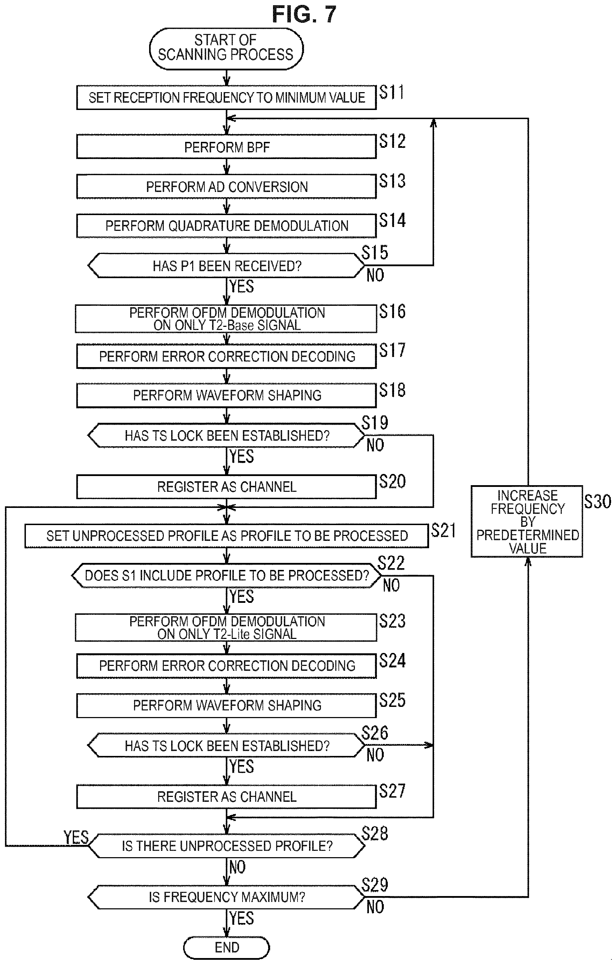

Next, a scanning process by the reception device of FIG. 1 will be described with reference to a flowchart of FIG. 7.

In step S11, the tuner controller 41 of the driver 22 controls the tuner 12 so that the tuner 12 sets a frequency which can be received to a minimum value, and supplies broadcast waves received by the antenna 11 to the BPF 13.

In step S12, the BPF 13 performs a band-pass filtering process on the signal received by the tuner 12 to extract only a predetermined frequency band, and outputs the resultant signal to the ADC 14.

In step S13, the ADC 14 converts the analog signal supplied from the BPF 13 into a digital signal, and supplies the digital signal to the quadrature demodulator 15.

In step S14, the quadrature demodulator 15 performs quadrature demodulation on the signal which has been converted into a digital signal, and outputs the resultant signal to the PI detector 16 and the sender 17.

In step S15, the PI detector 16 determines whether or not PI (PI symbol), which is a header in the frame of DVB-T2, has been detected in the supplied signal. For example, when it is determined in step S15 that P1 has not been detected, the process returns to step S12. In other words, the processes of steps S11 to S15 are repeated until the header PI has been supplied. For example, when PI has been detected in step S15, the process proceeds to step S16.

In step S16, the P1 detector 16 supplies the detected P1 to the P1 interpreter 21. The PI interpreter 21 interprets information of the supplied PI, and supplies, to the driver 22, information including S1 and S2 which is the result of the interpretation. The driver 22 recognizes that PI has been detected, based on the supply of the result of the interpretation of PI, and sends an instruction to the PI detector 16 to supply only DVB-T2-Base (T2-Base) to the OFDM demodulator 18. In response to this instruction, the P1 detector 16 controls the sender 17 so that the sender 17 subsequently sends only signals having the DVB-T2-Base (T2-Base) profile to the OFDM demodulator 18. As a result, the OFDM demodulator 18 demodulates only DVB-T2-Base (T2-Base) sequentially supplied by the sender 17, and supplies the resultant signal to the error correction decoder 19.

In step S17, the error correction decoder 19 performs an error correction decoding process on the supplied signal, and outputs the resultant signal to the waveform shaper 20.

In step S18, the waveform shaper 20 outputs the signal supplied from the error correction decoder 19 as a TS, and also supplies that signal to the driver 22 for feedback.

In step S19, the driver 22 controls the TS lock checker 43 so that the TS lock checker 43 determines whether or not the fed-back TS has been correctly decoded, and based on the result of the determination, determines whether or not TS lock has been established. For example, when it is determined in step S19 that the TS has been correctly decoded and TS lock has been established, the process proceeds to step S20.

In step S20, the driver 22 controls the tuner controller 41 so that the set frequency band in the current time zone is stored, as a channel in which signals having a received profile can be received, to the scanning result storage 23.

On the other hand, when, in step S19, TS lock has not been established, i.e., it is not recognized that the TS has been correctly decoded, the process of step S20 is skipped, and the frequency band is not registered as a receivable channel. Specifically, in this case, it is determined that this frequency band does not include a signal having a profile to be processed, and there is not a viewable or listenable channel.

In step S21, the driver 22 controls the profile changer 42 so that the profile changer 42 sets an unprocessed profile as a profile to be processed, and instructs the PI detector 16 to cause the sender 17 to send that profile to the OFDM demodulator 18. Specifically, in this case, in steps S16 to S20, DVB-T2-Base (T2-Base) has been processed as a profile, and therefore, DVB-T2-Lite (T2-Lite) which is an unprocessed profile is set as a profile to be processed. Therefore, in the description that follows, when S1, which indicates information of a profile, of PI indicates DVB-T2-Lite (T2-Lite), the PI detector 16 controls the sender 17 so that the sender 17 outputs a signal to the succeeding stage.

In step S22, the driver 22 controls the S1 recognizer 44 so that the PI detector 16 detects PI, and supplies information of PI to the PI interpreter 21. Moreover, the PI interpreter 21 interprets PI, and determines whether or not information of S1 as the result of the interpretation is DVB-T2-Lite (T2-Lite).

In step S22, for example, when the information of S1 as the result of the interpretation is DVB-T2-Lite (T2-Lite), the process proceeds to step S23.

In step S23, the driver 22 recognizes the detection of PI based on the supply of the interpretation result of PI, and instructs the P1 detector 16 to supply only DVB-T2-Lite (T2-Lite) to the OFDM demodulator 18. In response to this instruction, the PI detector 16 controls the sender 17 so that the sender 17 sends only signals having the DVB-T2-Lite (T2-Lite) profile, of signals subsequently supplied, to the OFDM demodulator 18. As a result, the OFDM demodulator 18 demodulates only DVB-T2-Lite (T2-Lite) supplied sequentially from the sender 17, and supplies the resultant signal to the error correction decoder 19.

In step S24, the error correction decoder 19 performs an error correction decoding process on the supplied signal, and outputs the resultant signal to the waveform shaper 20.

In step S25, the waveform shaper 20 outputs the signal supplied from the error correction decoder 19 as a TS, and supplies that signal to the driver 22 for feedback.

In step S26, the driver 22 controls the TS lock checker 43 so that the TS lock checker 43 determines whether or not the fed-back TS has been correctly decoded, and based on the result of the determination, determines whether or not TS lock has been established. For example, when it is determined in step S26 that the TS has been correctly decoded and TS lock has been established, the process proceeds to step S27.

In step S27, the driver 22 controls the tuner controller 41 so that the tuner controller 41 stores the set frequency band in the current time zone, as a channel in which the current profile can be received, to the scanning result storage 23.

On the other hand, when, in step S26, TS lock has not been established, i.e., it is not recognized that the TS has been correctly decoded, the process of step S27 is skipped.

In step S28, the driver 22 determines whether or not there is an unprocessed profile. In this case, there are two different profiles, i.e., DVB-T2-Base (T2-Base) and DVB-T2-Lite (T2-Lite), and therefore, it is determined that there is not an unprocessed profile, and the process proceeds to step S29.

In step S29, the driver 22 determines whether or not the frequency is maximum, and when the frequency is not maximum, the process proceeds to step S30.

In step S30, the driver 22 increases the frequency by a predetermined value, and the process returns to step S12. Thus, by the above processes, the processes of steps S12 to S30 are repeated until the frequency is maximum. Thereafter, when it is determined in step S29 that the frequency is maximum, the process ends.

On the other hand, when, in step S22, for example, the information of S1 as the result of the interpretation is not DVB-T2-Lite (T2-Lite), i.e., this band does not include a signal in which the information of S1 as the result of the interpretation is not DVB-T2-Lite (T2-Lite), the processes of steps S23 to S27 are skipped. In other words, in this band, when there is not a signal in which the information of S1 as the result of the interpretation is not DVB-T2-Lite (T2-Lite), in this band, scanning of a signal in which the information of S1 as the result of the interpretation is not DVB-T2-Lite (T2-Lite) is skipped. As a result, channel scanning is not performed for a plurality of profiles unless it is confirmed that there are a plurality of clearly different profiles, and therefore, the process can be sped up.

Also, in step S28, for example, when a new DVB-T2-X profile is added to the current profiles, the unprocessed DVB-T2-X profile is set as a new profile to be processed, and the processes of steps S22 to S27 are repeated. In other words, by this process, even if a new profile is additionally set, the processes of steps S22 to S27 are performed for the added profile, whereby the added profile can be dealt with. Moreover, even when a new profile is added, then if the profile is not included in this band, channel scanning is skipped in step S22. Therefore, even when a new profile is added, channel scanning can be performed only when necessary, and therefore, even when a profile is added, efficient and quick channel scanning can be achieved. Note that, although, in the foregoing, an example has been described in which only the DVB-T2-Base profile is first demodulated, and thereafter, only when a different profile is received, DVB-T2-Lite is demodulated as the different profile, the order may be switched.

### <2. Second Embodiment>

### [Example Configuration of Second Embodiment of Reception Device]

In the foregoing, an example has been described in which efficient and quick channel scanning can be achieved by using S1, which is information for identifying a profile provided in a signal specified in DVB-T2. Alternatively, a plurality of reception modes may be set, and by changing the plurality of reception modes, efficient and quick channel scanning and tuning may be achieved.

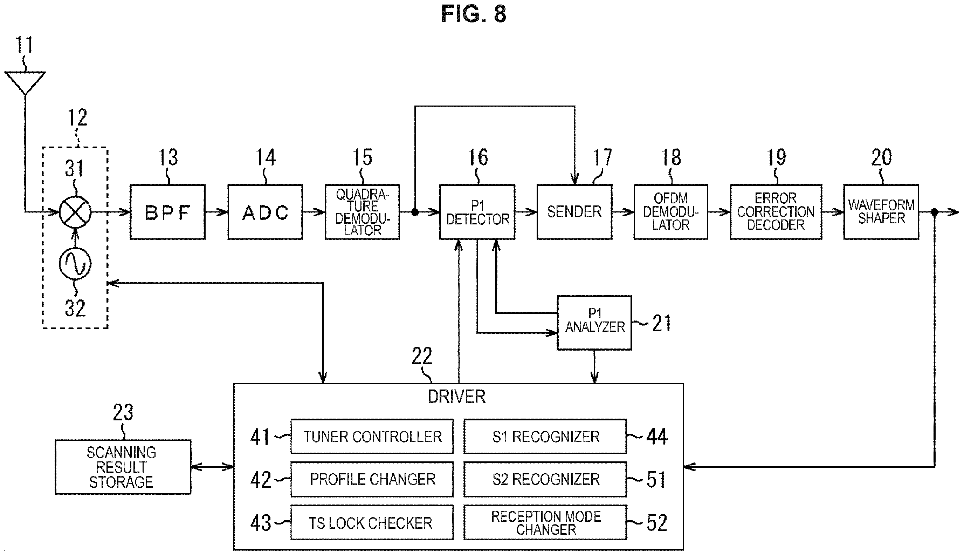

FIG. 8 shows an example configuration of a second embodiment of a reception device in which a plurality of reception modes are set, and by changing the plurality of reception modes, efficient and quick channel scanning and tuning are achieved. Note that, in the reception device of FIG. 8, configurations having the same functions as those of the reception device of FIG. 1 are given the same names and the same reference characters, and will not be described as appropriate. Specifically, the reception device of FIG. 8 is different from the reception device of FIG. 1 in that, in the driver 22, an S2 recognizer 51 and a reception mode changer 52 are provided.

The S2 recognizer 51 recognizes information of S2 (S2 field 2) included in the information of PI of the interpretation result supplied from the PI interpreter 21. Specifically, as described with reference to FIG. 4, the information of S2 is used to identify whether or not only the same profile is transmitted in the same frequency band, and is 0 when only the same profile is transmitted, and 1 when a mixture of a plurality of profiles is transmitted.

The reception mode changer 52 changes three different reception modes, i.e., first to third reception modes, based on the information of S1, which indicates a profile, and S2, which indicates whether or not a signal includes a plurality of profiles, S1 and S2 being the interpretation result supplied from the PI interpreter 21, thereby achieving a channel scanning process and a tuning process. More specifically, the first to third reception modes are changed by designating the profile of a signal to be sent by the sender 17 to the OFDM demodulator 18.

Specifically, the first reception mode is a reception mode in which a profile to be processed is not previously designated, a signal having a profile indicated by S1 included in PI which is first received is set as a profile to be processed, and subsequently, only signals in which the profile to be processed is included in PI are supplied from the sender 17 to the OFDM demodulator 18.

Also, the second reception mode is a reception mode in which only signals in which a previously set profile to be processed is the same as a profile indicated by S1 included in P1, are supplied from the sender 17 to the OFDM demodulator 18.

Moreover, the third reception mode is a reception mode in which only signals in which a previously set profile to be processed is the same as a profile indicated by S1 included in PI, are supplied from the sender 17 to the OFDM demodulator 18, and when a TS which is the result of the demodulation cannot be TS-locked, the profile to be processed is changed to an unprocessed profile, and a similar process is repeated.

The reception mode changer 52 changes the first reception mode and the third reception mode in a scanning process and a tuning process described below, thereby achieving efficient and quick processes.

### [Scanning Process of Reception Device of FIG. 8]

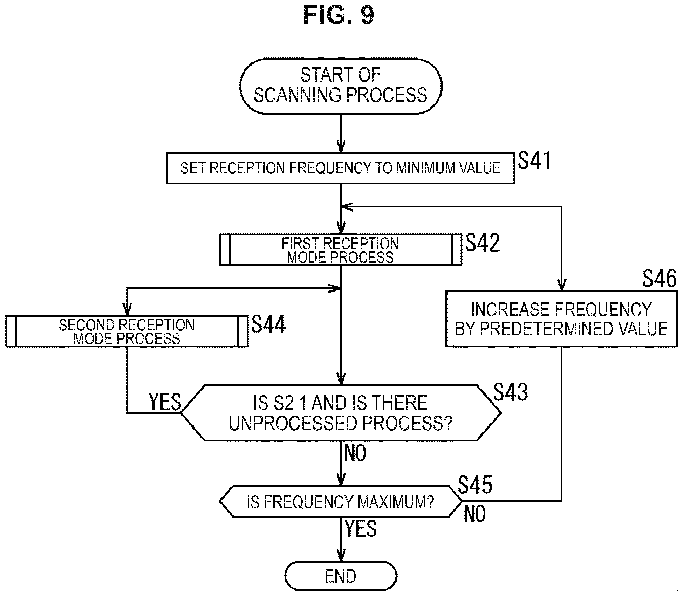

Next, a scanning process by the reception device of FIG. 8 will be described with reference to a flowchart of FIG. 9.

In step S41, the tuner controller 41 of the driver 22 controls the tuner 12 so that the tuner 12 sets a minimum frequency as a frequency which can be received, and supplies broadcast waves received by the antenna 11 to the BPF 13.

In step S42, the reception mode changer 52 sets the reception mode to the first reception mode so that the first reception mode process is performed.

### [First Reception Mode Process]

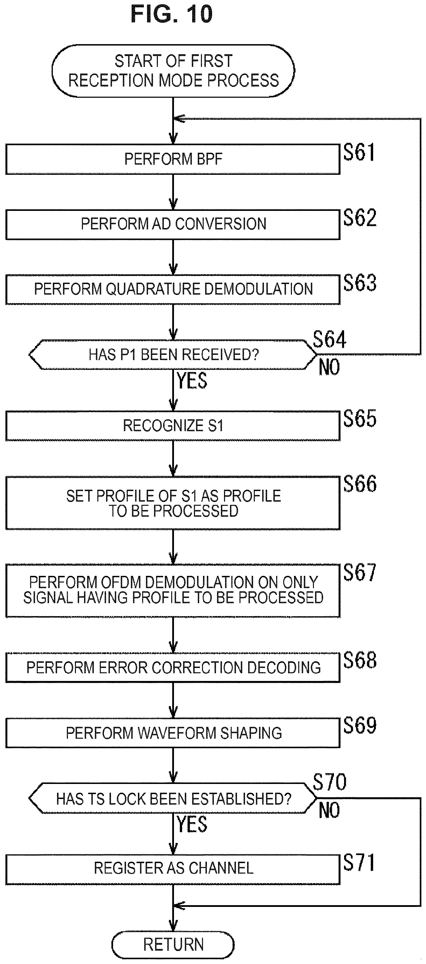

Here, the first reception mode will be described with reference to a flowchart of FIG. 10.

In step S61, the BPF 13 performs a band-pass filtering process on a signal received by the tuner 12 to extract only a predetermined frequency band, and outputs the resultant signal to the ADC 14.

In step S62, the ADC 14 converts the analog signal supplied from the BPF 13 into a digital signal, and supplies the digital signal to the quadrature demodulator 15.

In step S63, the quadrature demodulator 15 performs quadrature demodulation on the signal which has been converted into a digital signal, and supplies the resultant signal to the PI detector 16 and the sender 17.

In step S64, the PI detector 16 determines whether or not PI, which is a header of a frame of DVB-T2, has been detected in the supplied signal. When the PI detector 16 determines that PI is not present, i.e., PI has not been detected, the process returns to step S61. In other words, the processes of steps S61 to S64 are repeated until the header P1 has been supplied. For example, when P1 has been detected in step S64, the process proceeds to step S65.

In step S65, the PI detector 16 supplies the detected PI to the PI interpreter 21. The PI interpreter 21 interprets information of the supplied PI, and supplies information including S1 and S2 which is the result of the interpretation, to the driver 22. The driver 22 controls the S1 recognizer 44 so that the S1 recognizer 44 recognizes S1, i.e., the profile of the currently received PI, based on the supply of the interpretation result of P1.

In step S66, the driver 22 sets the information of S1 recognized by the S1 recognizer 44, i.e., the received profile of PI, as a profile to be processed.

In step S67, the driver 22 controls the profile changer 42 so that the profile changer 42 sends an instruction to the PI detector 16 to supply only signals having the process to be processed to the OFDM demodulator 18. In response to this instruction, the PI detector 16 controls the sender 17 so that the sender 17 sends only signals having the profile to be processed, of signals subsequently supplied, to the OFDM demodulator 18. As a result, the OFDM demodulator 18 demodulates only signals having the profile to be processed which are successively supplied from the sender 17, and supplies the resultant signals to the error correction decoder 19.

In step S68, the error correction decoder 19 performs an error correction decoding process on the supplied signal, and outputs the resultant signal to the waveform shaper 20.

In step S69, the waveform shaper 20 outputs the signal supplied from the error correction decoder 19 as a TS, and also supplies that signal to the driver 22 for feedback.

In step S70, the driver 22 controls the TS lock checker 43 so that the TS lock checker 43 determines whether or not the fed-back TS has been correctly decoded, and based on the result of the determination, determines whether or not TS lock has been established. For example, when it is determined in step S70 that the TS has been correctly decoded and TS lock has been established, the process proceeds to step S71.

In step S71, the driver 22 controls the tuner controller 41 so that the tuner controller 41 stores the set frequency band in the current time zone, as a channel in which the current profile can be received, to the scanning result storage 23.

On the other hand, when, in step S71, TS lock has not been established, i.e., it is not recognized that the TS has been correctly decoded, the process of step S71 is skipped.

Specifically, by the above first reception mode process, a signal having a profile included in PI which has been first received is demodulated, and here, when TS lock is confirmed, the frequency band is stored as a receivable channel in the scanning result storage 23. As a result, scanning is started from the profile which has been first received, and therefore, a situation that scanning is not started until a particular profile has been received is avoided, whereby the scanning process can be efficiently and quickly performed.

Now, we return to the description of the flowchart of FIG. 9.

In step S43, the driver 22 controls the S2 recognizer 51 so that the S2 recognizer 51 recognizes S2 of the interpretation result of PI supplied from the PI interpreter 21, and determines whether or not S2 is 1, i.e., whether or not a plurality of profiles are included in the current frequency band to be processed, and there is an unprocessed profile. For example, when, in step S43, S1 included in PI which has been first received is DVB-T2-Base, then if S2 is 1, DVB-T2-Lite is an unprocessed profile, and in step S43, it is determined that S2 is 1 and there is an unprocessed profile, and therefore, the process proceeds to step S44.

In step S44, the reception mode changer 52 changes the reception mode to the second reception mode so that the second reception mode process is performed.

### [Second Reception Mode Process]

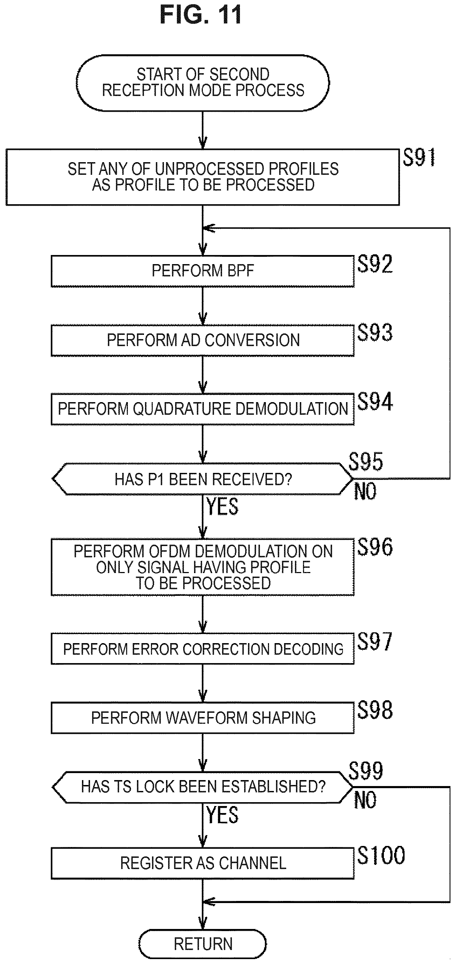

Here, the second reception mode process will be described with reference to a flowchart of FIG. 11.

In step S91, the driver 22 sets any of the unprocessed profiles as a profile to be processed. Specifically, for example, when the first reception mode process has set DVB-T2-Base as a profile to be processed, DVB-T2-Lite is an unprocessed profile, and therefore, DVB-T2-Lite is set as a profile to be processed.

In step S92, the BPF 13 performs a band-pass filtering process on a signal received from the tuner 12 to extract only a predetermined frequency band, and outputs the resultant signal to the ADC 14.

In step S93, the ADC 14 converts the analog signal supplied from the BPF 13 into a digital signal, and supplies the digital signal to the quadrature demodulator 15.

In step S94, the quadrature demodulator 15 performs quadrature demodulation on the signal which has been converted into a digital signal, and supplies the resultant signal to the PI detector 16 and the sender 17.

In step S95, the PI detector 16 determines whether or not PI, which is a header of a frame of DVB-T2, has been detected in the supplied signal. When the PI detector 16 determines that PI is not present, i.e., PI has not been detected, the process returns to step S92. In other words, the processes of steps S92 to S95 are repeated until the header PI has been supplied. For example, when PI has been detected in step S95, the process proceeds to step S96.

In step S96, the PI detector 16 supplies the detected PI to the PI interpreter 21. The PI interpreter 21 interprets information of the supplied PI, and supplies information including S1 and S2 which is the result of the interpretation, to the driver 22. The driver 22 recognizes the detection of PI based on the supply of the interpretation result of PI, and instructs the PI detector 16 to supply only signals having the profile to be processed to the OFDM demodulator 18. In response to this instruction, the PI detector 16 controls the sender 17 so that the sender 17 sends signals supplied following PI to the OFDM demodulator 18. As a result, the OFDM demodulator 18 demodulates only signals having the profile to be processed which are supplied sequentially from the sender 17, and supplies the resultant signals to the error correction decoder 19. In other words, in this case, only DVB-T2-Lite as the profile to be processed is sequentially demodulated.

In step S97, the error correction decoder 19 performs an error correction decoding process on the supplied signal, and outputs the resultant signal to the waveform shaper 20.

In step S98, the waveform shaper 20 outputs the signal supplied from the error correction decoder 19 as a TS, and also supplies that signal to the driver 22 for feedback.

In step S99, the driver 22 controls the TS lock checker 43 so that the TS lock checker 43 determines whether or not the fed-back TS has been correctly decoded, and based on the result of the determination, determines whether or not TS lock has been established. For example, when it is determined in step S99 that the TS has been correctly decoded and TS lock has been established, the process proceeds to step S100.

In step S100, the driver 22 controls the tuner controller 41 so that the tuner controller 41 stores the set frequency band in the current time zone, as a channel in which the current profile can be received, to the scanning result storage 23.

On the other hand, when, in step S99, TS lock has not been established, i.e., it is not recognized that the TS has been correctly decoded, the process of step S100 is skipped.

By the above processes, a signal having an unprocessed profile is demodulated and scanned, and when TS lock has been confirmed, the frequency band is registered as a viewable or listenable channel in the scanning result storage 23.

Now, we return to the description of the flowchart of FIG. 9.

When, in step S44, the second reception mode process is performed, the process returns to step S43.

Back in step S43, the driver 22 controls the S2 recognizer 51 so that the S2 recognizer 51 recognizes S2 of the interpretation result of PI supplied from the PI interpreter 21, and determines whether or not S2 is 1, i.e., a plurality of profiles are included in the current frequency band to be processed, and there is an unprocessed profile. In this case, DVB-T2-Base and DVB-T2-Lite which are profiles here set have been scanned, and therefore, there is not an unprocessed profile. Therefore, the process proceeds to step S45.

Note that when a profile is added in the future, e.g., a new DVB-T2-X profile is added, the process returns to step S44, in which DVB-T2-X is set as a profile to be processed, and the second reception mode process is performed. Thereafter, there is not an unprocessed profile, and therefore, the process proceeds to step S45.

In step S45, the driver 22 determines whether or not the frequency is maximum, and when the frequency is not maximum, the process proceeds to step S46.

In step S46, the driver 22 increases the frequency by a predetermined value, and the process returns to step S42. Thus, by the above processes, the processes of steps S42 to S46 are repeated until the frequency is maximum. Thereafter, when it is determined in step S45 that the frequency is maximum, the process ends.

Thus, by performing the first reception mode process and the second reception mode process in combination, it is no longer necessary to initially set a profile to be processed, and therefore, the scanning process can be simplified. Also, only when a mixture of a plurality of profiles is transmitted, scanning is performed for a plurality of profiles. Therefore, the opportunity for scanning a plurality of profiles can be minimized, and therefore, the time required for channel scanning can be reduced compared to when channel scanning is unconditionally performed for all profiles.

As a result, channel scanning can be efficiently and quickly performed on broadcast signals specified in DVB-T2.

### [Tuning Process]

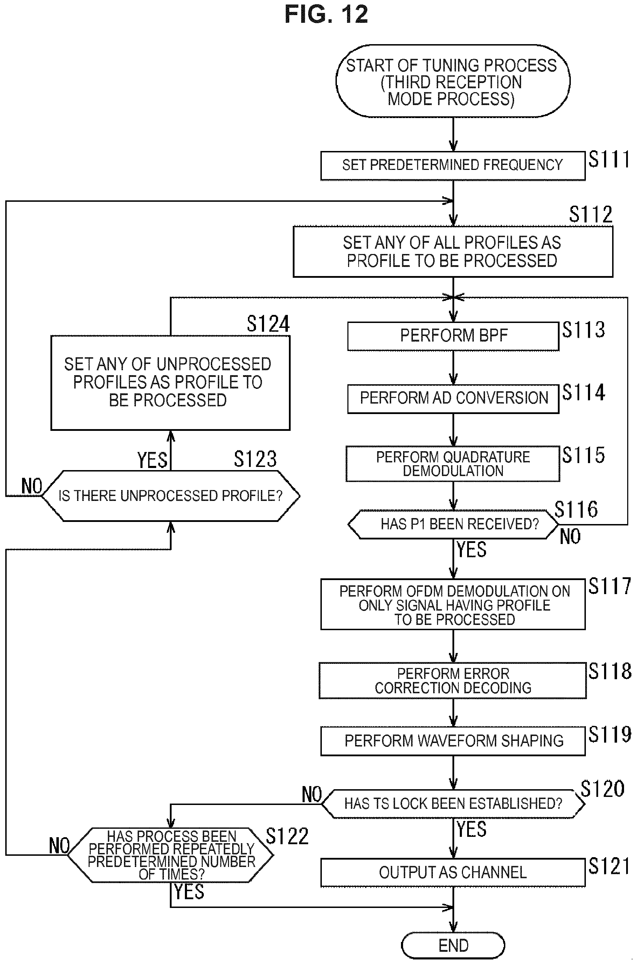

Next, a tuning process will be described with reference to a flowchart of FIG. 12. Note that this tuning process is performed on the assumption that the above scanning process is performed, so that a receivable channel is previously registered in the scanning result storage 23. Also, the tuning process is the third reception mode process itself.

In step S111, the driver 22, when obtaining information indicating a channel designated by the user operating an operation unit (not shown), reads information of a corresponding frequency from the scanning result storage 23, and controls the tuner controller 41 so that the tuner controller 41 is set to the corresponding frequency.

In step S112, the driver 22 sets any of the profiles registered as a scanning result corresponding the designated channel, as a profile to be processed. Specifically, for example, if both DVB-T2-Base and DVB-T2-Lite are registered as the scanning result, any of them is set as a profile to be processed. Also, when either of DVB-T2-Base and DVB-T2-Lite is registered as the scanning result, the registered profile is set as a profile to be processed.

In step S113, the BPF 13 performs a band-pass filtering process on the signal received by the tuner 12 to extract only a predetermined frequency band, and outputs the resultant signal to the ADC 14.

In step S114, the ADC 14 converts the analog signal supplied from the BPF 13 into a digital signal, and supplies the digital signal to the quadrature demodulator 15.

In step S115, the quadrature demodulator 15 performs quadrature demodulation on the signal which has been converted into a digital signal, and supplies the resultant signal to the PI detector 16 and the sender 17.

In step S116, the P1 detector 16 determines whether or not PI, which is a header of a frame of DVB-T2, has been detected in the supplied signal. When the PI detector 16 determines that PI is not present, i.e., PI has not been detected, the process returns to step S113. In other words, the processes of steps S113 to S116 are repeated until the header PI has been supplied. For example, when PI has been detected in step S116, the process proceeds to step S117.

In step S117, the PI detector 16 supplies the detected PI to the PI interpreter 21. The P1 interpreter 21 interprets information of the supplied PI, and supplies information including S1 and S2 which is the result of the interpretation, to the driver 22. The driver 22 recognizes the detection of P1 based on the supply of the interpretation result of PI, and instructs the PI detector 16 to supply only signals having the profile to be processed to the OFDM demodulator 18. In response to this instruction, the PI detector 16 controls the sender 17 so that the sender 17 sends signals supplied following PI to the OFDM demodulator 18. As a result, the OFDM demodulator 18 demodulates signals sequentially supplied from the sender 17, and supplies the resultant signals to the error correction decoder 19.

In step S118, the error correction decoder 19 performs an error correction decoding process on the supplied signal, and outputs the resultant signal to the waveform shaper 20.

In step S119, the waveform shaper 20 outputs the signal supplied from the error correction decoder 19 as a TS, and also supplies that signal to the driver 22 for feedback.

In step S120, the driver 22 controls the TS lock checker 43 so that the TS lock checker 43 determines whether or not the fed-back TS has been correctly decoded, and based on the result of the determination, determines whether or not TS lock has been established. For example, when it is determined in step S120 that the TS has been correctly decoded and TS lock has been established, the process proceeds to step S121.

In step S121, the driver 22 determines that the channel has been correctly tuned, and outputs a signal received while maintaining this state, and the process ends.

On the other hand, when, in step S120, TS lock has not been established, i.e., it is not recognized that the TS has been correctly decoded, the process proceeds to step S122.

In step S122, the driver 22 determines whether or not the series of processes of steps S112 to S120 has been performed repeatedly a predetermined number of times, and the number of times it has been determined that a viewable or listenable channel is not present is equal to a predetermined number of times. When it is determined that the processes have not been performed repeatedly the predetermined number of times, the process proceeds to step S123.

In step S123, the driver 22 determines whether or not there is an unprocessed profile. For example, when there is an unprocessed profile, the process proceeds to step S124. The unprocessed profile also includes a profile which is not registered in the scanning result storage 23.

In step S124, the driver 22 sets any of the unprocessed profiles as a profile to be processed, and the process returns to step S113. Specifically, as long as, in step S120, TS lock has not been recognized, and the number of times there is an unprocessed profile does not reach the predetermined number of times, the processes of steps S113 to S124 are repeated.

Moreover, when it is determined in step S123 that there is not an unprocessed profile, the process returns to step S112. Specifically, this is a state in which the process is started again from the beginning, and the processes of steps S112 to S124 are repeated until it is determined that the processes have been performed the predetermined number of times.

And, in step S120, when TS lock has been confirmed, the process proceeds to step S121, and the tuning process ends.

On the other hand, when it is determined in step S122 that the processes have been performed repeatedly a predetermined number of times, it is determined that the designated channel cannot be received, and the process ends.

By the above processes, the tuning process can be simplified. Also, when TS lock has not been confirmed, it is also determined whether or not a signal can be received using another profile. Therefore, after the channel scanning process has once been performed, tuning can be performed even if profiles are changed in the same frequency band.

Also, as to the tuning process, unlike the third reception mode process described with reference to the flowchart of FIG. 12, it may not always be necessary to tune in to a receivable channel while changing profiles until the failure to confirm TS lock has occurred a predetermined number of times. In such a case, for example, tuning may be performed by the second reception mode process described with reference to the flowchart of FIG. 11. Note that, in the case of the tuning process, instead of the process of step S91 of FIG. 11, based on information designating a channel supplied from an operation unit (not shown), the tuner 12 is set to a frequency registered in the scanning result storage 23, and the registered profile is set as a profile to be processed. Also, the process of step S100 is a process of outputting a signal for which TS lock has been confirmed, as a result of tuning.

Specifically, in the second reception mode process, a signal is output as a result of tuning only when TS lock has been confirmed simply based on a signal received using a profile registered in the scanning result storage 23. However, the tuning process itself can be simplified.

Thus, according to the present technology, a channel scanning process of a broadcast signal including a plurality of profiles specified in DVB-T2, and a channel tuning process following the channel scanning, can be simplified, and performed efficiently and quickly.

Incidentally, the above series of processes can, for example, be executed by hardware, or can be executed by software. In the case where the series of processes is executed by software, a program configuring this software is installed in a computer included in dedicated hardware, or a general-purpose personal computer which can execute various functions when various programs are installed, etc., from a recording medium.

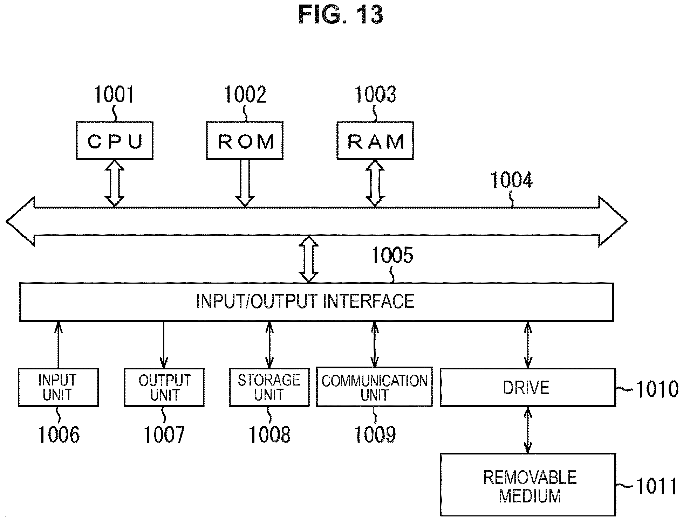

FIG. 13 shows an example configuration of a general-purpose personal computer. The computer includes a CPU (Central Processing Unit) 1001. An input/output interface 1005 is connected to the CPU 1001 through a bus 1004. A ROM (Read Only Memory) 1002 and a RAM (Random Access Memory) 1003 are connected to the bus 1004.

An input unit 1006 including an input device, such as a keyboard, a mouse, etc., which is used by the user to input an operation command, an output unit 1007 which outputs a process operation screen or an image of a process result to a display device, a storage unit 1008 including a hard disk drive etc. which stores a program or various items of data, and a communication unit 1009 including a LAN (Local Area Network) adaptor etc. which performs a communication process through a network typified by the Internet, are connected to the input/output interface 1005. Also, connected is a drive 1010 which reads and writes data from and to a removable medium 1011, such as a magnetic disk (including a flexible disk), an optical disk (including a CD-ROM (Compact Disc-Read Only Memory) and a DVD (Digital Versatile Disc)), an magneto-optical disk (including an MD (Mini Disc)), or a semiconductor memory, etc.

The CPU 1001 executes various processes according to a program stored in the ROM 1002 or a program which is read from the removable medium 1011, such as a magnetic disk, an optical disk, a magneto-optical disk, or a semiconductor memory, etc., is installed in the storage unit 1008, and is loaded from the storage unit 1008 to the RAM 1003. The RAM 1003 also stores data which is required when the CPU 1001 executes various processes, etc., as appropriate.

In the computer configured as described above, the CPU 1001 loads a program that is stored, for example, in the storage unit 1008 onto the RAM 1003 via the input/output interface 1005 and the bus 1004, and executes the program. Thus, the above-described series of processing is performed.

Programs to be executed by the computer (the CPU 1001) are provided being recorded in the removable medium 1011 which is a packaged medium or the like. Also, programs may be provided via a wired or wireless transmission medium, such as a local area network, the Internet or digital satellite broadcasting.

In the computer, by inserting the removable medium 1011 into the drive 1010, the program can be installed in the storage unit 1008 via the input/output interface 1005. Further, the program can be received by the communication unit 1009 via a wired or wireless transmission medium and installed in the storage unit 1008. Moreover, the program can be installed in advance in the ROM 1002 or the storage unit 1008.

It should be noted that the program executed by a computer may be a program that is processed in time series according to the sequence described in this specification or a program that is processed in parallel or at necessary timing such as upon calling.

Further, in the present disclosure, a system has the meaning of a set of a plurality of configured elements (such as an apparatus or a module (part)), and does not take into account whether or not all the configured elements are in the same casing. Therefore, the system may be either a plurality of apparatuses, stored in separate casings and connected through a network, or a plurality of modules within a single casing.

An embodiment of the disclosure is not limited to the embodiments described above, and various changes and modifications may be made without departing from the scope of the disclosure.

For example, the present disclosure can adopt a configuration of cloud computing which processes by allocating and connecting one function by a plurality of apparatuses through a network.

Further, each step described by the above mentioned flow charts can be executed by one apparatus or by allocating a plurality of apparatuses.

In addition, in the case where a plurality of processes is included in one step, the plurality of processes included in this one step can be executed by one apparatus or by allocating a plurality of apparatuses.

### Reference Signs List

- 11: antenna
- 12: tuner
- 13: BPF
- 14: ADC
- 15: quadrature demodulator
- 16: P1 detector
- 17: sender
- 18: OFDM demodulator
- 19: error correction decoder
- 20: waveform shaper
- 21: PI interpreter
- 22: driver
- 23: transfer transistor
- 41: tuner controller
- 42: profile changer
- 43: TS lock checker
- 44: S1 recognizer
- 51: S2 recognizer
- 52: reception mode changer

## Claims

1. A reception device configured
to receive digital video broadcast - terrestrial signals compliant with a DVB-T2 standard, the signals including at least two different profiles including a first profile and a second profile, and
to perform a channel scanning process for each of a plurality of reception frequency bands, and for each of the plurality of reception frequency bands,
to demodulate a signal having the first profile which is a first received profile or a predetermined profile, and
if the second profile is detected, to demodulate a signal having the second profile, or if the second profile is not detected, to skip the demodulating process for the second profile at a current frequency band.

2. A reception device according to claim 1 comprising:
a receiver (12) configured to receive the digital video broadcast - terrestrial signals;
a demodulator (18) configured to demodulate the signals received by the receiver; and
a signal controller (22) configured to supply the signals to be demodulated, to the demodulator.

3. The reception device according to claim 2, wherein
the signals include profile information indicating the profiles which are configurations of the signals,
the reception device further includes a profile information recognizer configured to recognize the profile information indicating the profiles which are the configurations of the signals received by the receiver, and
based on the profile information, the signal controller is configured to supply the signals to be demodulated, to the demodulator.

4. The reception device according to any of claims 1 to 3, wherein
the at least two different profiles include T2-Base and T2-Lite.

5. The reception device according to any of claims 2 to 4, further comprising:
a register configured to register a profile of a signal demodulated by the demodulator when the signal has been correctly demodulated, for each of the plurality of frequency bands.

6. The reception device according to claim 5, wherein
the signal includes a mixture signal indicating whether the signal includes a signal having only one of the profiles or a mixture of signals having at least two of the profiles, and
the reception device further includes a mixture recognizer which, based on the mixture signal, is configured to recognize whether the signal includes the signal having only one of the profiles or the mixture of signals having at least two of the profiles.

7. A reception method comprising:
receiving digital video broadcast - terrestrial signals compliant with a DVB-T2 standard, the signals including at least two different profiles including a first profile and a second profile; and
performing a channel scanning process for each of a plurality of reception frequency bands, and for each of the plurality of reception frequency bands,
demodulating a signal having the first profile, which is a first received profile or a predetermined profile, and
if the second profile is detected, demodulating a signal having the second profile, or if the second profile is not detected, skipping the demodulating process for the second profile at a current frequency band.

8. The reception method according to claim 7, wherein
the signals include profile information indicating the profiles which are configurations of the signals, and
the reception method further includes recognizing the profile information indicating the profiles which are the configurations of the received signals.

9. The reception method according to claim 7 or claim 8, wherein
the at least two different profiles include T2-Base and T2-Lite.

10. The reception method according to any of claims 7 to 9, further comprising:
registering a profile of a demodulated signal when the signal has been correctly demodulated for each of the plurality of frequency bands.

11. A program for causing a computer to execute a reception method comprising:
receiving digital video broadcast - terrestrial signals compliant with a DVB-T2 standard, the signals including at least two different profile including a first profile and a second profile; and
performing a channel scanning process for each of a plurality of reception frequency bands, and for each of the plurality of reception frequency bands,
demodulating a signal having the first profile, which is a first received profile or a predetermined profile, and
if the second profile is detected, to demodulate a signal having the second profile, or if the second profile is not detected, to skip the demodulating process for the second profile at a current frequency band.

## Patentansprüche

1. Empfangsvorrichtung, die konfiguriert ist zum
Empfangen terrestrischer digitaler Videorundfunksignale, die zu einer DVB-T2-Norm konform sind, wobei die Signale mindestens zwei verschiedene Profile enthalten, die ein erstes Profil und ein zweites Profil umfassen, und
Durchführen eines Kanalabtastprozesses für jedes von mehreren Empfangsfrequenzbändern; und für jedes der mehreren Empfangsfrequenzbänder zum
Demodulieren eines Signals, das das erste Profil, das ein erstes empfangenes Profil oder ein vorgegebenes Profil ist, besitzt, und
Demodulieren eines Signals, das das zweite Profil besitzt, wenn das zweite Profil detektiert wird, oder Auslassen des Demodulationsprozesses für das zweite Profil in einem aktuellen Frequenzband, wenn das zweite Profil nicht detektiert wird.

2. Empfangsvorrichtung nach Anspruch 1, die Folgendes umfasst:
einen Empfänger (12), der konfiguriert ist, die terrestrischen digitalen Videorundfunksignale zu empfangen;
einen Demodulator (18), der konfiguriert ist, die Signale, die durch den Empfänger empfangen wurden, zu demodulieren; und
eine Signalsteuereinheit (22), die konfiguriert ist, die Signale, die demoduliert werden sollen, dem Demodulator zuzuführen.

3. Empfangsvorrichtung nach Anspruch 2, wobei
die Signale Profilinformationen enthalten, die die Profile, die Konfigurationen der Signale sind, angeben,
die Empfangsvorrichtung ferner eine Profilinformationserkennungseinrichtung umfasst, die konfiguriert ist, die Profilinformationen zu erkennen, die die Profile, die die Konfigurationen der Signale, die durch den Empfänger empfangen wurden, sind, angeben, und
die Signalsteuereinheit konfiguriert ist, auf der Grundlage der Profilinformationen die Signale, die demoduliert werden sollen, dem Demodulator zuzuführen.

4. Empfangsvorrichtung nach einem der Ansprüche 1 bis 3, wobei
die mindestens zwei verschiedenen Profile T2-Basis und T2-Leicht enthalten.

5. Empfangsvorrichtung nach einem der Ansprüche 2 bis 4, die ferner Folgendes umfasst:
ein Register, das konfiguriert ist, ein Profil eines Signals, das durch den Demodulator demoduliert wurde, zu registrieren, wenn das Signal für jedes der mehreren Frequenzbänder korrekt demoduliert wurde.

6. Empfangsvorrichtung nach Anspruch 5, wobei
das Signal ein Signalgemisch enthält, das angibt, ob das Signal ein Signal, das lediglich eines der Profile besitzt, oder ein Gemisch von Signalen, das mindestens zwei der Profile besitzt, enthält, und
die Empfangsvorrichtung ferner eine Gemischerkennungseinrichtung enthält, die konfiguriert ist, auf der Grundlage des Signalgemischs zu erkennen, ob das Signal das Signal, das lediglich eines der Profile besitzt, oder das Gemisch von Signalen, das mindestens zwei der Profile besitzt, enthält.

7. Empfangsverfahren, das Folgendes umfasst:
Empfangen terrestrischer digitaler Videorundfunksignale, die zu einer DVB-T2-Norm konform sind, wobei die Signale mindestens zwei verschiedene Profile enthalten, die ein erstes Profil und ein zweites Profil enthalten; und
Durchführen eines Kanalabtastprozesses für jedes von mehreren Empfangsfrequenzbändern; und für jedes der mehreren Empfangsfrequenzbänder:
Demodulieren eines Signals, das das erste Profil, das ein erstes empfangenes Profil oder ein vorgegebenes Profil ist, besitzt, und
Demodulieren eines Signals, das das zweite Profil besitzt, wenn das zweite Profil detektiert wird, oder Auslassen des Demodulationsprozesses für das zweite Profil in einem aktuellen Frequenzband, wenn das zweite Profil nicht detektiert wird.

8. Empfangsverfahren nach Anspruch 7, wobei
die Signale Profilinformationen enthalten, die die Profile, die Konfigurationen der Signale sind, angeben, und
das Empfangsverfahren ferner ein Erkennen der Profilinformationen, die die Profile, die die Konfigurationen der empfangenen Signale sind, angeben, umfasst.

9. Empfangsverfahren nach Anspruch 7 oder Anspruch 8, wobei
die mindestens zwei verschiedenen Profile T2-Basis und T2-Leicht enthalten.

10. Empfangsverfahren nach einem der Ansprüche 7 bis 9, das ferner Folgendes umfasst:
Registrieren eines Profils eines demodulierten Signals, wenn das Signal für jedes der mehreren Frequenzbänder korrekt demoduliert wurde.

11. Programm, das einen Computer veranlasst, ein Empfangsverfahren auszuführen, das Folgendes umfasst:
Empfangen terrestrischer digitaler Videorundfunksignale, die zu einer DVB-T2-Norm konform sind, wobei die Signale mindestens zwei verschiedene Profile enthalten, die ein erstes Profil und ein zweites Profil enthalten; und
Durchführen eines Kanalabtastprozesses für jedes von mehreren Empfangsfrequenzbändern; und für jedes der mehreren Empfangsfrequenzbänder:
Demodulieren eines Signals, das das erste Profil, das ein erstes empfangenes Profil oder ein vorgegebenes Profil ist, besitzt, und
Demodulieren eines Signals, das das zweite Profil besitzt, wenn das zweite Profil detektiert wird, oder Auslassen des Demodulationsprozesses für das zweite Profil in einem aktuellen Frequenzband, wenn das zweite Profil nicht detektiert wird.

## Revendications

1. Dispositif de réception configuré :
pour recevoir des signaux terrestres de diffusion vidéo numérique conformes à une norme DVB-T2, les signaux comprenant au moins deux profils différents comprenant un premier profil et un deuxième profil, et
pour exécuter un processus de balayage de canal pour chacune d'une pluralité de bandes de fréquences de réception, et pour chacune de la pluralité de bandes de fréquences de réception,
pour démoduler un signal ayant le premier profil qui est un premier profil reçu ou un profil prédéterminé,
et
si le deuxième profil est détecté, pour démoduler un signal ayant le deuxième profil ou, si le deuxième profil n'est pas détecté, pour sauter le processus de démodulation pour le deuxième profil à une bande de fréquences courante.

2. Dispositif de réception selon la revendication 1 comprenant :
un récepteur (12) configuré pour recevoir les signaux terrestres de diffusion vidéo numérique ;
un démodulateur (18) configuré pour démoduler les signaux reçus par le récepteur ; et
un contrôleur de signaux (22) configuré pour fournir les signaux à démoduler au démodulateur.

3. Dispositif de réception selon la revendication 2, dans lequel :
les signaux comprennent des informations de profil indiquant les profils qui sont des configurations des signaux,
le dispositif de réception comprend en outre un dispositif de reconnaissance d'informations de profil configuré pour reconnaître les informations de profil indiquant les profils qui sont les configurations des signaux reçus par le récepteur, et
sur la base des informations de profil, le contrôleur de signaux est configuré pour fournir les signaux à démoduler au démodulateur.

4. Dispositif de réception selon l'une quelconque des revendications 1 à 3, dans lequel :
les au moins deux profils différents comprennent T2-Base et T2-Lite.

5. Dispositif de réception selon l'une quelconque des revendications 2 à 4, comprenant en outre :
un registre configuré pour enregistrer un profil d'un signal démodulé par le démodulateur lorsque le signal a été correctement démodulé, pour chacune de la pluralité de bandes de fréquences.

6. Dispositif de réception selon la revendication 5, dans lequel :
le signal comprend un signal de mélange indiquant si le signal comprend un signal ayant seulement un des profils ou un mélange de signaux ayant au moins deux des profils, et
le dispositif de réception comprend en outre un dispositif de reconnaissance de mélange qui, sur la base du signal de mélange, est configuré pour reconnaître si le signal comprend le signal ayant seulement un des profils ou le mélange de signaux ayant au moins deux des profils.

7. Procédé de réception comprenant les étapes suivantes :
recevoir des signaux terrestres de diffusion vidéo numérique conformes à une norme DVB-T2, les signaux comprenant au moins deux profils différents comprenant un premier profil et un deuxième profil ; et
exécuter un processus de balayage de canal pour chacune d'une pluralité de bandes de fréquences de réception,
et pour chacune de la pluralité de bandes de fréquences de réception,
démoduler un signal ayant le premier profil, qui est un premier profil reçu ou un profil prédéterminé, et
si le deuxième profil est détecté, démoduler un signal ayant le deuxième profil ou, si le deuxième profil n'est pas détecté, sauter le processus de démodulation pour le deuxième profil à une bande de fréquences courante.

8. Procédé de réception selon la revendication 7, dans lequel :
les signaux comprennent des informations de profil indiquant les profils qui sont des configurations des signaux, et
le procédé de réception comprend en outre de reconnaître les informations de profil indiquant les profils qui sont les configurations des signaux reçus.

9. Procédé de réception selon la revendication 7 ou la revendication 8, dans lequel :
les au moins deux profils différents comprennent T2-Base et T2-Lite.

10. Procédé de réception selon l'une quelconque des revendications 7 à 9, le procédé comprenant en outre l'étape suivante :
enregistrer un profil d'un signal démodulé lorsque le signal a été correctement démodulé pour chacune de la pluralité de bandes de fréquences.

11. Programme destiné à amener un ordinateur à exécuter un procédé de réception comprenant les étapes suivantes :
recevoir des signaux terrestres de diffusion vidéo numérique conformes à une norme DVB-T2, les signaux comprenant au moins deux profils différents comprenant un premier profil et un deuxième profil ; et
exécuter un processus de balayage de canal pour chacune d'une pluralité de bandes de fréquences de réception,
et pour chacune de la pluralité de bandes de fréquences de réception,
démoduler un signal ayant le premier profil, qui est un premier profil reçu ou un profil prédéterminé, et
si le deuxième profil est détecté, démoduler un signal ayant le deuxième profil ou, si le deuxième profil n'est pas détecté, sauter le processus de démodulation pour le deuxième profil à une bande de fréquences courante.
